**Europäisches Patentamt**

**European Patent Office**

**Office européen des brevets**

(11) Publication number: **0 058 958**
**B1**

(12) **EUROPEAN PATENT SPECIFICATION**

(45) Date of publication of patent specification: **29.10.86**

(21) Application number: **82101282.0**

(22) Date of filing: **19.02.82**

(51) Int. Cl.⁴: **H 03 K 19/094**

(54) Complementary MOSFET logic circuit.

(30) Priority: **25.02.81 JP 26376/81**
**24.06.81 JP 97712/81**
**06.11.81 JP 178162/81**

(43) Date of publication of application:
**01.09.82 Bulletin 82/35**

(45) Publication of the grant of the patent:
**29.10.86 Bulletin 86/44**

(84) Designated Contracting States:
**DE FR GB IT NL**

(56) References cited:
**FR-A-2 373 921**
**US-A-3 631 528**
**US-A-4 301 383**

**ELECTRONIC DESIGN, Vol. 26, No. 23**
**November 1978 "CMOS: Higher Speeds, More**
**Drive and analog Capability Expand its**
**Horizons" pages 74 to 82**

(73) Proprietor: **Kabushiki Kaisha Toshiba**
**72, Horikawa-cho Saiwai-ku**
**Kawasaki-shi Kanagawa-ken 210 (JP)**

(72) Inventor: **Suzuki, Yasoji**
**1-7-10, Uragaoka**
**Yokosuka-shi Kanagawa-ken (JP)**
Inventor: **Matsuo, Kenji**
**2408-209, 2-4-3, Shiomidai**
**Isogo-ku Yokohama-shi (JP)**

(74) Representative: **Henkel, Feiler, Hänzel & Partner**
**Möhlstrasse 37**
**D-8000 München 80 (DE)**

(56) References cited:

**RADIO FERNSEHEN ELEKTRONIK, Vol. 26, No.**
**3, 1977 G. GURINSKY "Zusammenschaltung**
**von digitalen CMOS-Schaltkreisen mit anderen**
**Logik-Familien" pages 76 to 78**

## Description

The present invention relates to a high speed complementary MOSFET logic circuit compatible with a TTL circuit.

An integrated circuit formed of complementary MOSFETs (referred to as CMOSFETs) has many advantages such as low power dissipation, a high noise-tolerance and a wide dynamic voltage range. Since the operation of the CMOSFET circuit with such advantages, is slower than the TTL circuit (transistor—transistor logic) however, it is replaced by the TTL circuit only when the circuit is in a relatively slow operation. A remarkable recent progress of microelectronics technology realizes high speed operable CMOSFETs. Many attempts have been made to realize a high performance circuit with low power dissipation and a high speed operation in which a low power but high speed CMOSFET circuit, in place of the high power TTL circuit, is combined with an LS (Low power Schottky) TTL circuit having a relatively lower power dissipation.

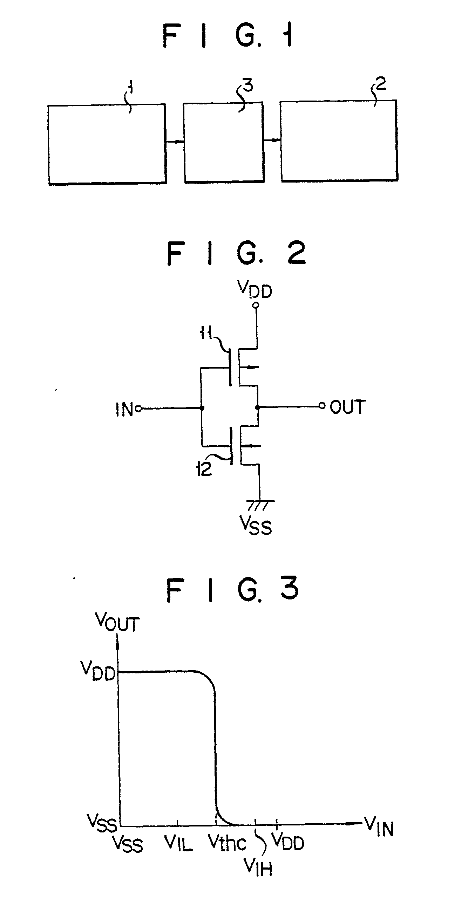

With respect to an output characteristic of the TTL circuit such as the LS-TTL circuit, when the power source voltage $V_{DD}$ is 5 V, a high level voltage $V_{OH}$ is approximately 2 V minimum and a low level voltage $V_{OL}$ is approximately 0.8 V maximum. An input voltage characteristic of the CMOSFET circuit, when the power source voltage $V_{DD}$ is 5 V, a high level voltage $V_{IH}$ is approximately 4 V, a low level voltage $V_{IL}$ is approximately 1 V, and a circuit threshold voltage $V_{thc}$ is half of the power source voltage $V_{DD}$, i.e. approximately 2.5 V. When a high speed CMOSFET circuit 2 is applied to an excessive power dissipation part in a system circuit most of which is formed of the LS-TTL circuit 1, an interface circuit 3 such as a boost circuit must be provided at the prestage of the CMOSFET circuit 2, as shown in Fig. 1. For obtaining a high speed CMOSFET circuit which is perfectly compatible with the TTL circuit, without the interface circuit 3, its input characteristic must be modified so as to be adaptable for the output characteristic of the TTL circuit. For example, when the $V_{DD}$ is 5 V, the input voltage characteristic of the CMOSFET circuit must be set such that $V_{IH} \approx 2$ V and $V_{IL} \approx 0.8$ V, in order to comply with the output level of the TTL circuit.

Fig. 2 shows a circuit diagram of a prior CMOS inverter in which a P channel MOSFET (referred to as a PMOSFET) 11 and an N channel MOSFET (referred to as an NMOSFET) 12 are inserted in series between power source voltage $V_{DD}$ and $V_{SS}$, an input signal IN is applied commonly to the gates of the FETs 11 and 12, and an output signal OUT is derived from a junction of the FETs 11 and 12. The inverter thus arranged has an input voltage $V_{IN}$ vs. output voltage $V_{OUT}$ characteristic as shown in Fig. 3. An input voltage $V_{IN}$ when the output voltage $V_{OUT}$ shifts from $V_{SS}$ to $V_{DD}$ or vice versa is a circuit threshold voltage $V_{thc}$. The circuit threshold voltage, when the FETs 11 and 12 are in a saturated state, is expressed by the following equation

$$V_{thc} = \frac{V_{thN} + \sqrt{K_P/K_N}(V_{DD} - |V_{thP}|)}{1 + \sqrt{K_P/K_N}} \qquad (1)$$

where

$V_{thN}$: threshold voltage of the NMOSFET
$V_{thP}$: threshold voltage of the PMOSFET
$K_P$ : coefficient of the source-drain current of the PMOSFET
$K_N$ : coeffient of the source-drain current of the NMOSFET

These coefficients $K_P$ and $K_N$ are also

$$K_P = \frac{1}{2} \cdot \frac{W_P}{L_P} \cdot \frac{\varepsilon_{ox}}{t_{ox}} \cdot \mu_P \qquad (2)$$

$$K_{NN} = \frac{1}{2} \cdot \frac{W_N}{L_N} \cdot \frac{\varepsilon_{ox}}{t_{ox}} \cdot \mu_N \qquad (3)$$

where

$W_P$ : channel width of the PMOSFET
$W_N$ : channel width of the NMOSFET
$L_P$ : channel length of the PMOSFET
$L_N$ : channel length of the NMOSFET
$t_{ox}$ : thickness of the gate oxide film
$\varepsilon_{ox}$ : dielectric constant
$\mu_P$ : effective mobility of holes
$\mu_N$ : effective mobility of electrons

As seen from equation (1), in order to improve the electrical characteristics of the input voltage $V_{IH}$ and $V_{IL}$ of the high speed CMOSFET circuit (inverter), that is to say, to change the input voltage $V_{IH}$ from 4 V to 2 V when $V_{DD} = 5$ V or to make the threshold voltage $V_{thc}$ small, the $|V_{thP}|$ is made large and the coefficient $K_P$ is made small. This may be attained by making the value of the conductance $g_m$ of the PMOSFET 11 smaller than that of a normal CMOS inverter. When these factors $|V_{thP}|$ and $K_P$ are changed as just mentioned, however, a rise time $t_r$, for example, when the high speed CMOS inverter operates is made larger than that before those are changed, resulting in deterioration of the operation speed of the inverter. Thus, the prior CMOSFET circuit has a difficulty in gaining both the high operation speed and the perfect compatibility with the TTL circuit.

Document US—A—3,631,528 discloses a low-power complementary driver comprising a first complementary inverter with a special circuit for turning the N-channel device off before the P-channel device is turned on and vice versa to greatly reduce power consumption. This is accomplished by two additional complementary inverters having diferent transition voltages connected between the input signal and the gates of the N and P-channel devices, respectively, of the first complementary inverter. A complementary - bipolar inverter is provided using the same technique with one of said additional inverters being replaced by a double inverter. In this low power complementary device a MOSFET element is connected in parallel with a bipolar transistor for the purpose to enable the output signal to swing to the full magnitude. The transition voltage of the first complementary inverter is changed by varying the ratio of the channel sizes of the N-channel device and the P-channel device.

Furthermore, document "Electronic Design", Volume 26, No. 23, November 8th, 1978, pages 74—82 discloses complementary MOSFET circuits drafted as an inverter, a NOR circuit or a NAND circuit and the combination of such circuits with a TTL circuit.

It is an object of the present invention to provide a complementary MOSFET logic circuit which has an electric characteristic providing a perfect compatibility with a TTL circuit, which is capable to swing a voltage amplitude of an output signal up to the power source voltage, and which can sustain its normal operation even when the power source voltage drops from a normal value to a low value.

According to the present invention, there is provided a TTL compatible complementary MOSFET logic circuit comprising:

an input terminal to which at least one input signal is supplied; a circuit output terminal from which one logic signal is output, a complementary MOSFET subcircuit having at least one P channel MOSFET, at least one N channel MOSFET and a subcircuit output terminal from which a subcircuit output signal is output, and receiving the at least one input signal; a buffer circuit in which a bipolar transistor receiving at its base the subcircuit output signal and at least one N channel MOSFET receiving at its gate the at least one input signal are inserted in series between a high potential applying point and a low potential applying point, thereby outputting an output signal to said circuit output terminal which is common to both the bipolar transistor and the at least one N channel MOSFET, and at least one first P channel MOSFET inserted between said circuit output terminal and said high potential applying point and receiving at its gate the at least one input signal, said complementary MOSFET logic circuit being characterized in that the ratio of the channel sizes of said at least one P channel MOSFET and said at least one N channel MOSFET in said complementary MOSFET subcircuit and the threshold voltages of said MOSFETs are set at such values as to produce an input voltage characteristic in said complementary MOSFET subcircuit corresponding to an output voltage characteristic of a TTL circuit, and that at least one second P channel MOSFET is inserted between said high potential applying point and the subcircuit output terminal to which the output signal of said complementary MOSFET subcircuit is supplied which at least one second P channel MOSFET is set at a lower threshold voltage than that of the P channel MOSFETs in said complementary MOSFET subcircuit and receives at its gates the input signal (IN) or signals (IN1; IN2) respectively.

This invention can be more fully understood from the following detailed description when taken in conjunction with the accompanying drawings, in which:

Fig. 1 is a block diagram for illustrating how a prior high speed CMOSFET circuit is applied to a TTL circuit;

Fig. 2 shows a circuit diagram of a prior CMOS inverter arrangement;

Fig. 3 illustrates a relationship of input and output voltages in a CMOS inverter;

Fig. 4 shows a circuit diagram of an embodiment of a conventional complementary MOSFET logic circuit;

Fig. 5 shows a circuit diagram of another embodiment of a complementary MOSFET logic circuit;

Fig. 6 shows a circuit diagram of yet another embodiment of a complementary MOSFET logic circuit;

Fig. 7 shows a circuit diagram of still another embodiment of a complementary MOSFET logic circuit;

Fig. 8 shows a circuit diagram of a further embodiment of a complementary MOSFET logic circuit;

Fig. 9 is an equivalent circuit of the circuit shown in Fig. 8;

Fig. 10 is a circuit diagram of still a further embodiment of a complementary MOSFET logic circuit;

Fig. 11 is an equivalent circuit of the circuit shown in Fig. 10;

Fig. 12 is a circuit diagram of an even further embodiment of a complementary MOSFET logic circuit;

Fig. 13 shows an equivalent circuit of the circuit shown in Fig. 12;

Fig. 14 is a circuit diagram of a further object of a complementary MOSFET logic circuit;

Fig. 15 shows an equivalent circuit of the circuit shown in Fig. 14;

Fig. 16 is a circuit diagram of a complementary MOSFET logic circuit;

Fig. 17 is a circuit diagram of an additional embodiment of a complementary MOSFET logic circuit;

Fig. 18 is a circuit diagram of a complementary MOSFET logic circuit;

Fig. 19 is a circuit diagram of a complementary MOSFET logic circuit;

Fig. 20 is a circuit diagram of a complementary MOSFET logic circuit which is an embodiment of the present invention;

Fig. 21 is a circuit diagram of a complementary MOSFET logic circuit which is a further embodiment of the present invention;

Fig. 22 is circuit diagram of a complementary MOSFET logic circuit according to still another embodiment of the present invention; and

Fig. 23 is a circuit diagram of a complementary MOSFET logic circuit according to an embodiment of the present invention.

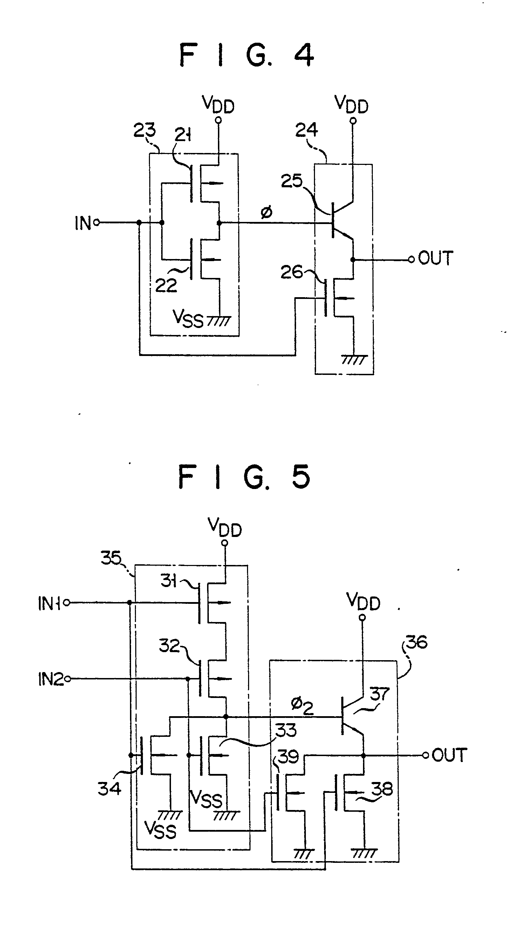

Fig. 4 shows a conventional complementary MOSFET logic circuit. As shown, the logic circuit has a CMOSFET subcircuit 23 as a CMOS inverter, in which a PMOSFET 21 and an NMOSFET 22 inserted in series between power source voltages $V_{DD}$ and $V_{SS}$ (high and low potential applying points). An input signal IN is applied to the gates of the PMOSFET 21 and the NMOSFET 22. An output signal $\phi$ of the CMOSFET subcircuit 23 derived from a junction between the PMOSFET 21 and the NMOSFET 22 is applied to the base of the bipolar transistor 25 in a buffer circuit 24. The buffer circuit 24 is comprised of the bipolar transistor 25 and the NMOSFET 26 receiving at the gate the input signal IN, which are inserted between the power source voltage $V_{DD}$ and $V_{SS}$. An output signal OUT is derived from the emitter of the transistor 25 in the buffer circuit 24.

The operation of the circuit as mentioned above will be described. In a condition that the CMOSFET subcircuit 23 is compatible with a TTL circuit of 2.0 V and 0.8 V for an input voltages $V_{IH}$ and $V_{IL}$ when $V_{DD}$=5 V, an electrical characteristic allowing a normal operation of the CMOSFET subcircuit 23 must be set up, that is, by making small the threshold voltage $V_{thc}$ of the CMOSFET subcircuit. In case where the CMOSFET subcircuit is fabricated by the conventional CMOS process, and the circuit threshold voltage $V_{thc}$ is set at a small value, for example, 1 to 2 V, when the threshold voltages $|V_{thP}|$ and $V_{thN}$ of the PMOSFET 21 and the NMOSFET 22 have conventional values (normally 1 V or so) and only the coefficient $K_P$ or $K_N$ is changed in equation (1), the PMOSFET 21 and NMOSFET 22 are both turned on when IN=$V_{IH}$=+2.0 V and a DC pass-current is generated. As a result, a low power dissipation feature which is an essential feature of the CMOSFET is lost. Therefore, the threshold voltages $|V_{thP}|$ and $V_{thN}$ of the PMOS and NMOSFETs 21 and 22 must be selected so as to avoid such a problem. To turn off the PMOSFET 21 when $V_{IN}$=$V_{IH}$, the threshold voltage $|V_{thP}|$ is

$$|V_{thP}| \geqq V_{DD} - V_{IH} \qquad (4)$$

To turn off the NMOSFET 22 when $V_{IN}$=$V_{IL}$ (to make high level the output Q from the CMOSFET subcircuit 23), the threshold voltage $V_{thN}$ is

$$V_{thN} \geqq V_{IL} \qquad (5)$$

Specifically, these threshold voltages must be set to:

$$|V_{thP}| \geqq 3.0 \text{ V and } V_{thN} \geqq 0.8 \text{ V}.$$

These values of the threshold voltages may be obtained by subjecting the PMOS and NMOSFETs 21 and 22 to the conventional surface concentration control process or the like.

To hold the high speed operation of the CMOSFET subcircuit 23 with such electric characteristic, there is needed a buffer circuit 24. The operation speed of the CMOSFET circuit 23, that is, a transient time $t_{sw}$ (rise time $t_r$ and fall time $t_f$) of the switching is generally given by the following relation (6)

$$t_{sw} \propto C_L/I_{DS} \qquad (6)$$

where $C_L$ represents a load capacitance and $I_{DS}$ indicates a source-drain current. If $I_{DS}$ is a saturation current,

$$I_{DS} = K(V_{gs} - V_{th})^2 \qquad (7)$$

where $V_{gs}$ indicates a gate-source voltage.

In order to suppress the increase of the transient time $t_{sw}$ and to hold the high speed operation in the prior CMOSFET circuit, it is necessary to prevent the decrease the saturation current $I_{DS}$ per unit load capacitance from being decreased. Specifically, in connection with the rise time $t_r$, when $V_{IN}$=$V_{IL}$ and the PMOSFET 21 is turned on, the gate-source voltage $V_{gsP}$ of the PMOSFET 21 is

$$|V_{gsP}| = V_{DD} - V_{IL} \simeq 5 - 0.8 \simeq 4.2 \text{ V} \qquad (8)$$

The $|V_{gsP}|$ is little different from that of the prior high speed CMOSFET circuit

$$(4 \text{ V}: V_{IH} \simeq 4 \text{ V}, V_{IL} \simeq 1 \text{ V}).$$

therefore, it is seen from equation (7) that a change of that threshold $|V_{thP}|$ of the PMOSFET 21 substantially effects the $I_{DS}$, i.e. the rise time $t_r$. The threshold $|V_{thP}|$ was set to, $|V_{thP}|$=3.0 V, from a view point of the low power consumption. If it is assumed that $|V_{thP}|$=3 V, from the relations (7) and (8), we have

$$(|V_{gs}| - |V_{thP}|)^2 = (4.2-3)^2 = 1.44 \qquad (9)$$

Similarly, the prior high speed CMOSFET circuit has the following relation

$$(|V_{gsP}| - |V_{thP}|)^2 = (4-1)^2 \simeq 9 \qquad (10)$$

In the meantime, when elements outside the IC are directly driven by an output signal from a general CMOS inverter (fabricated into an IC), the load capacitance $C_L$ is large. In the present example, $C_L \simeq 20$PF. Since the load capacitance $C_L$ of the CMOSFET circuit is present within the IC, its value is small, $C_L \simeq 1$PF. The value of 1PF corresponds to an interconnection length of 3,380 μm when the interconnection width is 6 μm and the thickness of the field oxide film is 7,000 Å, having a sufficient margin. Accordingly, in order that the rise time $t_r$ is equal to that of the prior CMOSFET circuit, when the coefficient of the $I_{DS}$ of the PMOSFET in CMOSFET circuit is $K_P'$, from the relations (6), (7), (9) and (10), we have coefficient $K_P$ of the PMOSFET 21 given by

$$K_P = K_P' \cdot \frac{1}{20} \cdot \frac{9}{1.44} \simeq 0.3\, K_P' \qquad (11)$$

The rise time $t_r$ of the output signal OUT is

$$K_P = 0.6\, K_P' \qquad (12)$$

because it passes through the transistor 25.

In connection with the fall time $t_f$, when the NMOSFET 22 is ON in a condition that $V_{IN}=V_{IH}$, the gate-source voltage $V_{gsN}$ of the NMOSFET 22 is

$$V_{gsN} = V_{IH} \simeq 2.0\ V \qquad (13)$$

When the gate-source voltage $V_{gsN}$ is compared to that of the prior high speed CMOSFET circuit ($V_{IH} \simeq 4\ V$), the difference of them is two times of the value of the $V_{gsN}$. Therefore, this greatly influences the fall time $t_f$. When $V_{thN}=0.8\ V$, as in the previous case, from equation (13), we have

$$(V_{gsN}-V_{thN})^2 = (2.0-0.8)^2 = 1.44 \qquad (14)$$

Similarly, when assuming that $V_{thN}=1\ V$ in the high speed CMOSFET circuit,

$$(V_{gsN}-V_{thN})^2 = (4-1)^2 = 9 \qquad (15)$$

Accordingly, in order that the fall time $t_f$ is equal to that of the prior high speed CMOSFET circuit, from relations (6), (7), (14) and (15), we have the coefficient $K_N$ of the NMOSFET 22 given below

$$K_N = K_N' \cdot \frac{1}{20} \cdot \frac{9}{1.44} \simeq 0.3\, K_N' \qquad (16)$$

where $K_N'$ is the coefficient of the $I_{DS}$ of the NMOSFET in the prior CMOS circuit.

In this way, the rise time $t_r$ and the fall time $t_f$ of the output signal $\phi$ from the CMOSFET subcircuit 23 can set the coefficients $K_P$ and $K_N$ of the PMOSFET 21 and the NMOSFET 22 so as to correspond to the prior high speed CMOSFET circuit. However, the rise time $t_{ro}$ and the fall time $t_{fo}$ of the output signal OUT for driving the external elements are determined by the buffer circuit 24. The rise time $t_{ro}$ of the output signal OUT depends on a current amplification factor $\beta$ (common emitter amplification factor) of the bipolar transistor 25 supplied with the signal $\phi$. The current drive power of the transistor 25 corresponds to $K_P \cdot \beta$. Generally, in the transistor 25 (in this case, an NPN type transistor) when it is manufactured in a factory, $\beta \simeq 50$ to 100. Accordingly, a sufficient current drive power can be obtained so that it is easy to change the rise time $t_{ro}$ to the time $t_r$. Further, the fall time $t_{fo}$ of the output signal OUT depends on the coefficient $K_{N2}$ of the $I_{DS}$ of the NMOSFET 26. When the load capacitance $C_L$ is equal to that (20PF) of the CMOSFET circuit,

$$K_{N2} \simeq K_N' \cdot \frac{20}{20} \cdot \frac{9}{1.44} \simeq 6\, K_N' \qquad (17)$$

In the normal manufacturing process of the CMOSFETs, the following relations hold; $\mu_P : \mu_N \simeq 1:2$ and $W_P : W_N \simeq 2:1$. From equations (2), (3), (12) and (16), the ratios of the coefficients $K_P$, $K_N$ and $K_{N2}$ of the PMOSFET 21, NMOSFET 22 and NMOSFET 26 are expressed in terms of the channel widths $W_P$, $W_N$ and $W_{N2}$ by

$$W_P : W_N = 4:1 \qquad (18)$$

$$W_N : W_{N2} = 1:20 \qquad (19)$$

The equation (19) may be replaced by $W_N : W_{N2} = 1:12$ when the threshold votage $V_{thN}$ is reduced down to approximately 0.5 V.

As described above, if the threshold value $V_{thc}$ of the CMOSFET circuit 23 is made small (specifically, the $|V_{thP}|$ is made large and the coefficient $K_P$ is made small) in order to perfectly adapt the CMOSFET circuit for the TTL circuit in their electrical characteristics, the rise time $t_{ro}$ and the fall time $t_{fo}$ of the output signal OUT may be made small by the buffer circuit 24 comprised of a bipolar transistor 25 with a large current amplification factor and an NMOSFET 26 with a large coefficient $K_N$ of the $I_{DS}$. Thus, the CMOS inverter with a high speed operation can be constructed without deteriorating its operation speed.

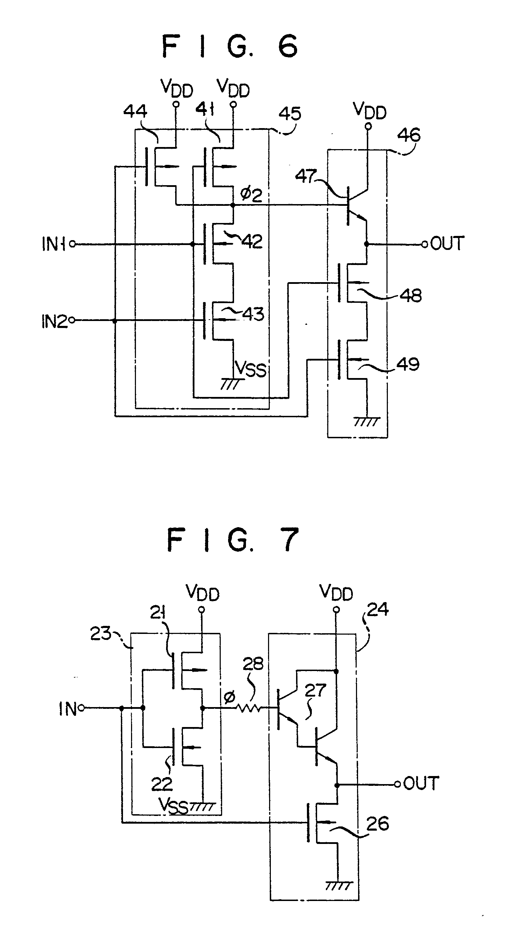

Turning now to Figs. 5 and 6, there are shown other embodiments of a complementary MOSFET logic circuit. The embodiment shown in Fig. 5, relates to a conventional two-input NOR circuit and the embodiment of Fig. 6 relates to a conventional two-input NAND circuit. In the CMOS NOR circuit shown in Fig. 5, PMOSFETs 31 and 32 and an NMOSFET 33 are connected in series between power source voltages $V_{DD}$ and $V_{SS}$. An NMOSFET 34 is connected in parallel with the NMOSFET 33. The circuit arrangement constitutes a CMOSFET subcircuit 35 as the CMOS NOR circuit. An output signal $\phi$ of the CMOSFET subcircuit 35 derived from a connection point of the PMOSFET 32 and the NMOSFET 33 is supplied to the base of the bipolar transistor 37 in the buffer circuit 36. The buffer circuit 36 is comprised of the bipolar transistor 37 inserted between the power source voltages $V_{DD}$ and $V_{SS}$ and two parallel arranged NMOSFETs 38 and 39 inserted between them through the bipolar transistor 37. An input signal IN1 is applied to the gates of the PMOSFET 31 and the NMOSFET 34 in the CMOSFET circuit 35 and the NMOSFET 38 is the buffer circuit 34. Another input signal IN2 is applied to the gates of the PMOSFET 32 and the NMOSFET 33 in the CMOSFET circuit 35 and the NMOSFET 39 in the buffer circuit 36. An output signal OUT is derived from the emitter of the transistor 37 in the buffer circuit 36.

In the CMOS NAND circuit shown in Fig. 6, a PMOSFET 41 and NMOSFETs 42 and 43 are inserted in series between the power source voltages $V_{DD}$ and $V_{SS}$. A PMOSFET 44 is connected in parallel with the PMOSFET 41. The circuit arrangement constitutes a CMOSFET subcircuit 45 as the CMOS NAND circuit. An output signal $\phi 2$ of the CMOSFET subcircuit 45 derived from a junction point of the PMOSFET 41 and the NMOSFET 42 in the CMOSFET subcircuit 45 is applied to the base of the bipolar transistor 47 in a buffer circuit 46. The buffer circuit 46 is comprised of a bipolar transistor 47 and two NMOSFETs 48 and 49, which are connected in series between the power source voltages $V_{DD}$ and $V_{SS}$. An input signal IN1 is applied to the gates of the PMOSFET 41 and the NMOSFET 42 in the CMOSFET subcircuit 45 and the NMOSFET 48 of the buffer circuit 46. Another input signal IN2 is applied to the gates of the PMOSFET 44 and the NMOSFET 43 in the CMOSFET subcircuit 45 and the NMOSFET 49 in the buffer circuit 46. A circuit output signal OUT is derived from the emitter of the transistor 47 in the buffer circuit 46.

In the CMOS NOR circuit and the CMOS NAND circuit thus arranged, the circuit threshold voltage $V_{thc}$, or $V_{thP}$ and $V_{thN}$, are selected as in the CMOS inverter in the embodiment as mentioned above. The ratio of the channel widths of the PMOSFET and NMOSFET in the arrangement having two series connected MOSFETs in double when compared to that of the inverter. More specifically, in the case of the CMOS NOR circuit, the channel width ratio of PMOSFET 31: NMOSFET 34 and PMOSFET 32: NMOSFET 33 (designated as $W_P$ and $W_N$) is

$$W_P : W_N = 8 : 1 \qquad (20)$$

In the case of the CMOS NAND circuit, the channel width ratio of $W_P$ and $W_N$ of PMOSFET 41: NMOSFET 42 and PMOSFET 44: NMOSFET 43 is

$$W_P : W_N = 4 : 2 \qquad (21)$$

The ratio of the channel widths $W_N$ and $W_{N2}$ of NMOSFET 42: NMOSFET 48 and NMOSFET 43: NMOSFET 49 is

$$W_N : W_{N2} = 4 : 24 \qquad (22)$$

The CMOS NOR circuit and the CMOS NAND circuit can keep their high speed operation by the bipolar transistors 37 and 47 in the buffer circuits 36 and 46, respectively, as in the case of the CMOS inverter.

Fig. 7 illustrates another embodiment of a complementary MOSFET logic circuit. The present embodiment employs a bipolar transistor 27 Darlington connected in place of the bipolar transistor 25 of the CMOS inverter shown in Fig. 4. The output signal $\phi$ of the CMOSFET subcircuit 23 is applied to the base of the Darlington transistor 27 in the buffer circuit 24, by way of a resistor 28.

In the thus arranged CMOS inverter, the resistor 28 is provided for ensuring a stable operation of the bipolar transistor 27 without being thermally broken down. The transistor 27 is used for increase the current amplification factor $\beta$ and speeding up the operation of the overall circuit.

Thus, the complementary MOSFET logic circuit shown in each of Figs. 4 to 7, can obtain the electrical characteristic allowing a complete compatibility of it with the TTL circuit. These CMOSFET logic circuits additionally need the buffer circuits when compared to the prior high speed CMOSFET circuit, resulting the increase of the manufacturing cost and the chip area when those are fabricated in the IC. However, when comparing with the prior high speed CMOSFET circuit containing the interface circuit necessary for its adaptation for the TTL circuit, such increase of the manufacturing cost and the chip area is remarkably small.

The CMOS inverter shown in Fig. 4 or 7, the CMOS NOR circuit shown in Fig. 5 or the CMOS NAND circuit shown in Fig. 6 has a disadvantage that the high level voltage of the circuit output signal OUT does not reach the amplitude of the power source voltage $V_{DD}$. This arises from the fact that a band gap voltage is present in the bipolar transistor, and that a junction voltage of some 0.6 V is generated between the base and emitter of the transistor 25, 37, 47 or the Darlington transistor 27. Therefore, if the voltage of the output signal $\phi$, $\phi 2$ or $\phi 3$ of the CMOSFET subcircuit 23, 35 or 45 rises to the full amplitude of $V_{DD}$, the voltage of the circuit output signal OUT saturates at $(V_{DD} - 0.6)$ V, so that an offset voltage appears in the high level voltage of the circuit output signal OUT.

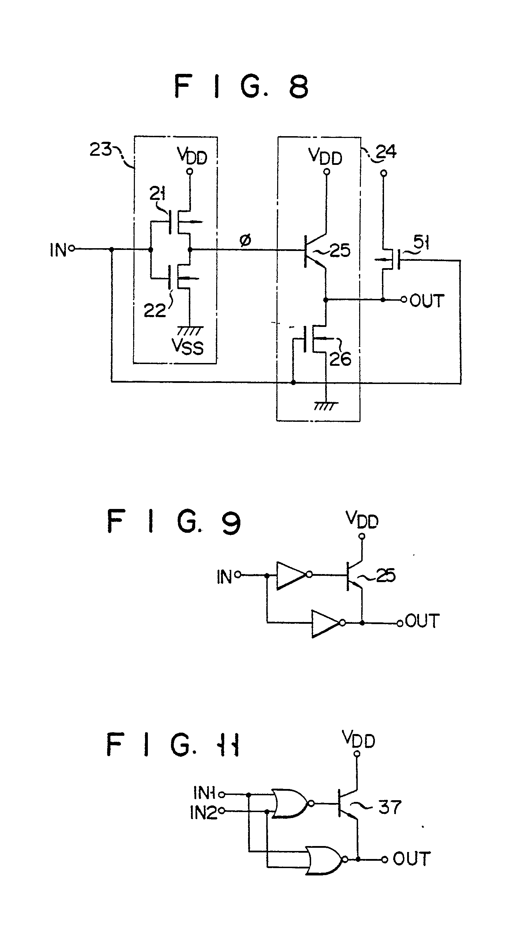

Another embodiment of a complementary MOSFET logic circuit shown in Fig. 8 is designed such that a measure for compensating for an offset voltage appearing in the high level voltage of the circuit output signal OUT is applied for the circuit shown in Fig. 4. In more particular, a PMOSFET 51 is connected in parallel with the bipolar transistor 25 in the buffer circuit 24 in the circuit shown in Fig. 4. An input signal IN is applied to the gate of the PMOSFET 51.

In the circuit thus constructed, if the theshold voltage $V_{thc}$ of the CMOSFET subcircuit 23 is made small in order to obtain its perfect adaptation with the output voltage characteristic of the TTL circuit, the rise time $t_{ro}$ and the fall time $t_{fo}$ of the circuit output signal OUT may be reduced by the bipolar transistor 25 with a large current drive power and the NMOSFET 26 with a large coefficient $K_N$ of $I_{DS}$. This indicates that the high speed operation of the circuit is not deteriorated. When the additional PMOSFET 51 is not used, the circuit output signal OUT does not swing up to $V_{DD}$, to produce an offset voltage of some 0.6 V. At the time that the PMOSFET 21 in the CMOSFET subcircuit 23 is turned on and the transistor 25 is driven by the signal $\phi$, the PMOSFET 51 has already been turned on by the input signal IN. Accordingly, when the base-emitter voltage of the transistor 25 approaches to 0.6 V, it is charged to the full magnitude of $V_{DD}$. Therefore, the circuit output signal OUT may be swung to the full amplitude of $V_{DD}$, when it is in a high level.

In connection with the PMOSFET 51, only the necessity is to compensate for the offset voltage' due to the base-emitter voltage of the transistor 25. Therefore, its $g_m$ may be small. This implies that the size of the element may be reduced, and that the increase of the chip size due to the addition of the PMOSFET 51 is negligible.

In Fig. 8, the CMOSFET subcircuit 23 made up of the PMOSFET 21 and the NMOSFET 22 is a CMOS inverter. The PMOSFET 51 and NMOSFET 26 also form a CMOS inverter. The equivalent circuit of the Fig. 8 circuit is as shown in Fig. 9.

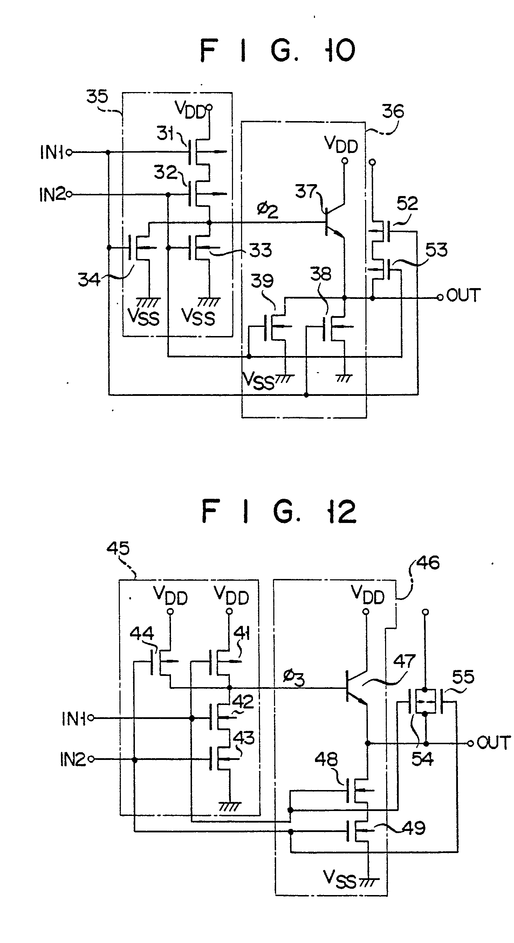

Fig. 10 shows a complementary MOSFET logic circuit, in which a measure for compensating for an offset voltage appearing in the high voltage of the output signal OUT is applied for the circuit shown in Fig. 5. Two PMOSFETs 52 and 53 connected in series are connected in parallel with the bipolar transistor 37 of the buffer circuit 36 in the circuit shown in Fig. 5. An input signal IN1 is applied for the gate of the PMOSFET 52, while another input signal IN2 is applied to the gate of the PMOSFET 53.

Also in the circuit thus constructed, if the threshold voltage $V_{thc}$ of the CMOSFET subcircuit 35 is made small in order to obtain the perfect adaptation with the output voltage characteristic of the TTL circuit, the rise time $t_{ro}$ and the fall time $t_{fo}$ of the circuit output signal OUT may be made small by the bipolar transistor 37 with a large current drive power and the NMOSFET 38 or 39 with a large coefficient of $I_{DS}$. Therefore, in the circuit shown in Fig. 10, there is no deterioration of the high speed operation. Further, if the base-emitter voltage is asymptotic to 0.6 V because of the addition of two PMOSFETs 52 and 53, the circuit output signal OUT is charged up to the full amplitude of $V_{DD}$ by both the PMOSFETs 52 and 53. Additionally, only the compensation of the offset voltage due to the base-emitter voltage of the transistor 37 is required for the PMOSFETs 52 and 53. Therefore, the reduction of the element size is possible. Therefore, the increase of the chip size due to the addition of the PMOSFETs 52 and 53 is almost negligible.

In Fig. 10, the CMOSFET subcircuit 35 made up of PMOSFETs 31 to 34 is a CMOS NOR circuit. The PMOSFETs 52 and 53 and the NMOSFETs 38 and 39 form a CMOS NOR circuit. Accordingly, the equivalent circuit shown in Fig. 10 is as shown in Fig. 11.

In Fig. 12 illustrating another embodiment of a complementary MOSFET logic circuit, a measure for compensating for an offset voltage produced in the high level voltage of the circuit output signal OUT is applied for the Fig. 6 circuit. In the circuit, two PMOSFETs 54 and 55 are connected in parallel with the bipolar transistor of the buffer circuit 46 in the Fig. 6 circuit. An input signal IN1 is applied to the gate of one of the PMOSFET 54, while another input signal IN2 is applied for the gate of the other PMOSFET 55.

In the circuit arrangement as mentioned above, as in the Fig. 6 circuit, if the circuit threshold voltage $V_{thc}$ of the CMOSFET subcircuit 45 is made small to obtain the perfect compatibility with the output voltage characteristic of the TTL circuit, the rise time $t_{ro}$ and the fall time $t_{fo}$ of the circuit output signal OUT may be made small by the bipolar transistor 47 with a large current drive power and the NMOSFETs 48 and 49 with a large coefficient $K_N$ of the $I_{DS}$. The Fig. 12 circuit does not damage the high speed operation. Because of the addition of two PMOSFETs 54 and 55, if the base-emitter voltage of the transistor 47 approaches to 0.6 V, the circuit output signal OUT is fully charged to the $V_{DD}$ by the PMOSFETs 54 and 55. Only the compensation of the offset voltage due to the base-emitter voltage is required for the PMOSFETs 54 and 55. Accordingly, the element size reduction is possible. As a consequence, the chip size increase due to the addition of the PMOSFETs 54 and 55 is almost negligible.

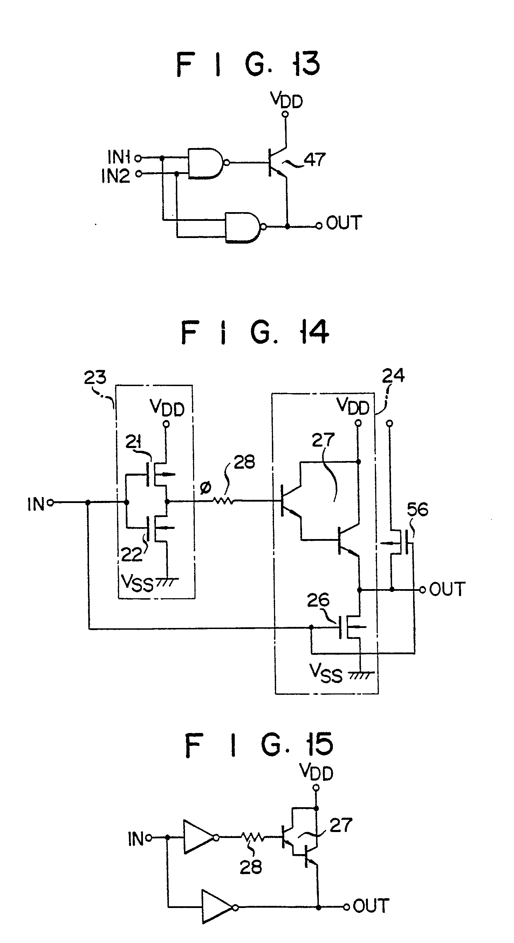

In Fig. 12, a CMOSFET subcircuit 45 made up of the PMOSFETs 41 and 44 and NMOSFETs 42 and 43 is a CMOS NAND circuit. Since the PMOSFETs 54 and 55, and NMOSFETs 48 and 49 form a CMOS NAND circuit, an equivalent circuit of the Fig. 12 circuit is as shown in Fig. 13.

Fig. 14 shows a further embodiment of a complementary MOSFET logic circuit. In the figure, a measure of compensating the offset voltage appearing in the high level voltage of the circuit output signal OUT is applied for the Fig. 7 circuit. In the circuit, a PMOSFET 56 is connected in parallel with the bipolar transistor 27 of the buffer circuit 24 in the Fig. 7 circuit. An input signal IN is applied for the gate of the PMOSFET 56.

In the circuit arrangement of the present embodiment, as in the Fig. 7 circuit, if the threshold voltage $V_{thc}$ of the CMOSFET subcircuit 23 is in order to obtain the perfect compatibility with the output voltage characteristic of the TTL circuit, the rise time $t_{ro}$ and the fall time $t_{fo}$ of the output signal OUT may be made small by the Darlington transistor 27 with a large current drive power and an NMOSFET 26 with a large coefficient $K_N$ of $I_{DS}$. Accordingly, no deterioration of the high speed operation of the circuit ensues. Because of the addition of the PMOSFET 56, if the base-emitter voltage of the transistor 27 approaches to 0.6 V, the PMOSFET 56 charges the circuit output signal OUT to be charged up to the $V_{DD}$. Also in this case, only the compensation of the offset voltage due to the base-emitter voltage of the transistor 27 for the PMOSFET 56 enables the elements to be size-reduced. Accordingly, the chip size increase due to the addition of the PMOSFET 56 is almost negligible.

In Fig. 14, a CMOSFET subcircuit 23 including a PMOSFET 21 and an NMOSFET 22 is a CMOS inverter. A PMOSFET 56 and an NMOSFET 26 form a CMOS inverter. The equivalent circuit of the Fig. 14 circuit is as shown in Fig. 15.

Thus, the complementary MOSFET logic circuit shown in Fig. 8, 10, 12 or 14 has an electrical characteristic perfectly compatible with that of the TTL circuit, and is capable of swing the voltage amplitude of the circuit output signal OUT to the power source voltage $V_{DD}$.

In the circuit shown in Fig. 4, when the $V_{DD}$ is 5 V and the high voltage $V_{IH}$ of the input signal IN is 2.0 V, the gate bias voltage of the PMOSFET 21 is $(V_{DD}-V_{TH})\simeq 3$ V. The DC pass-current is produced unless the theshold voltage $|V_{thP}|$ of the PMOSFET 21 is above 3.0 V. Accordingly, when the $V_{DD}$ is fixed to 5 V, if $|V_{thP}|\simeq 3.0$ V, the low power consumption is secured. If some cause drives the consumption of the battery to progress when the circuit is battery-driven, and $V_{DD}$ reduces from 5 V to 3 V, the circuit shown in Fig. 4 fails to secure a stable operation.

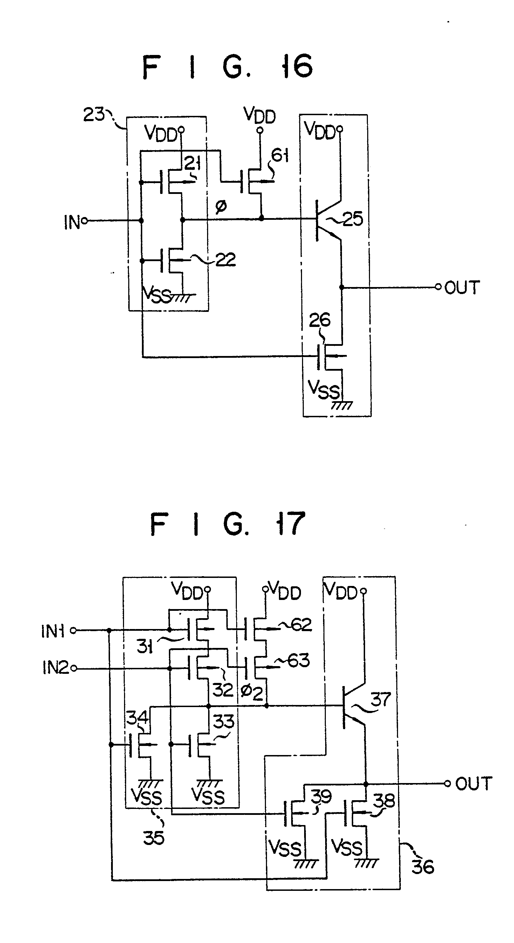

In Fig. 16 illustrating another embodiment of a complementary MOSFET logic circuit, a measure for securing a stable operation when the power source voltage $V_{DD}$ drops from a normal value is applied for the circuit shown in Fig. 4. More specifically, a PMOSFET 61 is connected between the output terminal of the CMOS subcircuit 23, i.e. a series connection point of the PMOSFET 21 and PMOSFET 61, and the power source $V_{DD}$ in Fig. 4. An input signal IN is applied to the gate of the PMOSFET 61. The threshold voltage $V_{thP}$ of the PMOSFET 61 is fabricated different from that of the PMOSFET 21 in the CMOSFET subcircuit 23. The prior art is so designed as to have an optimum operation under a condition: the $g_m$ ratio of the PMOSFET 21 and NMOSFET 22 is 4:1, the threshold voltage $V_{thP}$ of the PMOSFET 21 is approximately $-3.0$ V, the threshold voltage $V_{thN}$ of the NMOSFET 22 is approximately 0.8 V, the high level voltage $V_{IH}$ of the input signal IN is nearly equal to 2.0 V, and its low level voltage $V_{IL}=0.8$ V. The threshold voltage of the additionally used PMOSFET 61 is about $-1.0$ V, and the $g_m$ ratio of the PMOSFET 21 and PMOSFET 61 is 4:1

With such an arrangement, when $V_{DD}=5$ V and the input signal is 2.0 V $(=V_{IH})$, the PMOSFET 21 is completely turned off and the NMOSFET 22 is completely turned on. Since its $g_m$ is much smaller than that of the NMOSFET 22, the signal $\phi$ is low in level. At this time, the PMOSFET 61 is ON. Accordingly, the DC pass-current is produced. Nevertheless, this is very small, when compared with the case that the threshold voltage of the PMOSFET 21 is simply small. The DC pass-current $I_{DD}$ (DC) may be expressed by the following proportional relation

$$I_{DD}(D.C)\propto g_{mP}(V_{DD}-V_{IH}-|Vth_P|)^2 \quad (32)$$

Since the $g_m$ of the PMOSFET 21 is four times that of the PMOSFET 61, the pass current when the PMOSFET 61 is provided is smaller than that when such is not provided.

When the $V_{DD}$ is 3.8 V, if an input signal IN=0.8 V is inputted, the PMOSFET 21 is not turned on, but the PMOSFET 61 is turned on. That is to say, when the voltage $V_{DD}$ drops to 3.8 V, the output signal $\phi$ is not high in level when the PMOSFET 61 is not provided. When it is provided, it forms a current path, so that the signal $\phi$ is high in level. The current $I_{DSP61}$ flowing through the PMOSFET 61 is given by

$$I_{DSP61}\propto g_{mP61}(V_{DD}-V_{IL}-|V_{thP61}|)^2\propto 4\cdot g_{mP21}$$

$$(24)$$

$g_{mP61}$: $g_m$ of PMOSFET 61
$g_{mP21}$: $g_m$ of PMOSFET 21
When $V_{DD}=5$ V and $V_{IL}=0.8$ V and the PMOSFETs 21 and 61 are both ON, the drain currents $I_{DSP21}$ and $I_{DSP61}$ are

$$I_{DSP21}\propto 1.44\, gm_{P21} \quad (25)$$

$$I_{DSP61}\propto 10.24\, g_{mP61} \quad (26)$$

Since the sum of the drain currents flows, $g_{mP21}$: $g_{mp61}=4:1$ is substituted into the above equations and the drive powers of the FET when $V_{DD}=5$ V and $V_{DD}=3.8$ V will be compared with each other,

$$\frac{I_{DSP61}(V_{DD}=3.8\text{ V})}{I_{DSP21}(V_{DD}=5\text{ V})+I_{DSP61}(V_{DD}=5\text{ V})}$$

$$\simeq \frac{4\times 1}{1.44\times 4+10.24\times 1} \simeq \frac{1}{4} \quad (27)$$

As seen from the above relation, the drive power of the PMOSFET when $V_{DD}=5$ V is 1/4 that when $V_{DD}=3.8$ V. Accordingly, the rise time of the signal $\phi$ is large. In general the CMOSFET circuit, when the power source voltage drops, the switching time increases as a matter of course. Increase of the switching time is not matter.

When the voltage $V_{DD}$ drops to 3.8 V, if $V_{DD}$ satisfies the relation

$$V_{DD}>V_{IL}-|V_{thP61}|\simeq 1.8\text{ V},$$

the stable operation is ensured. If the $V_{thP61}$ is set at $-1.0$ V, as in the previous case, the circuit operates normally even if $V_{DD}$ drops to 2 V or so. Further, by properly setting the $g_m$ ratios of the PMOSFETs 21 and 61, the DC pass-current caused by the input level change may be limited small.

As described above, the above embodiment has an electrical characteristic perfectly compatible with that of the TTL circuit and ensures its normal operation when the power source voltage drops from its normal value, with a minimum power consumption.

Turning now to Fig. 17, there is shown a further embodiment of a complementary CMOSFET logic circuit. In the present embodiment, a measure for the power source voltage drop is taken and applied for the Fig. 5 circuit. In the circuit, two PMOSFETs 62 and 63 are connected between the output terminal of the CMOSFET subcircuit 35 in the circuit shown in Fig. 5, i.e. a connection point of the PMOSFET 32 and the NMOSFET 33, and a power source $V_{DD}$. An input signal IN1 is applied to the gate of the PMOSFET 62 and another input signal IN2 is applied to the gate of the PMOSFET 63. In the circuit the threshold voltages of the two PMOSFETs 31 and 32 in the CMOSFET subcircuit 35 are set to be equal to each other and those of the PMOSFETs 62 and 63 are set in a similar way. And the threshold voltage of each of the PMOSFET 62 or 63 is set to be larger (smaller in the absolute value) then that of the PMOSFET 31 or 32. In this way, a normal operation of the circuit is ensured when the power source voltage drops. Further, by selecting the $g_m$ values of the PMOSFETs 31 and 32 to be larger than those of the PMOSFETs 62 and 63, the DC pass-current and the power consumption may be made small.

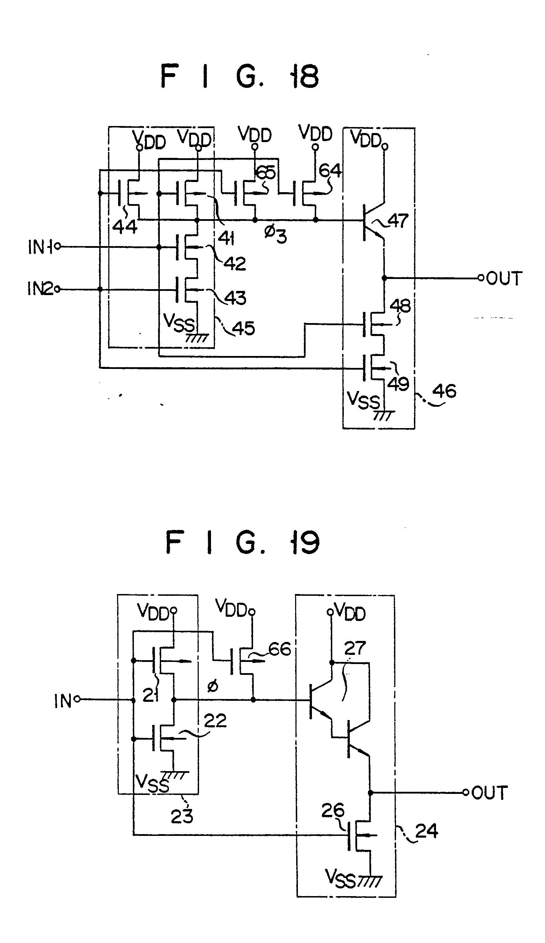

Fig. 18 shows an even further embodiment of a complementary MOSFET logic circuit. In the present embodiment, a measure for the power source voltage reduction is taken and applied for the Fig. 6 circuit. In the present embodiment, two PMOSFETs 64 and 65 are connected in parallel between the output terminal of the CMOSFET subcircuit 45 in the Fig. 6 circuit, i.e. a connection point between the PMOSFET 41 and the NMOSFET 42, and the power source $V_{DD}$. An input signal IN1 is applied to the gate of the PMOSFET 64 and another input signal IN2 is applied to the gate of the PMOSFET 65. In the circuit, the threshold voltages of the two PMOSFETs 41 and 44 in the MOSFET subcircuit 45 are selected to be equal to each other. Similarly, the threshold voltages of the PMOSFETs 64 and 65 are equally selected. Further, the threshold voltage of each of the PMOSFETs 64 and 65 is selected to be larger (smaller in the absolute value) than that of each of the PMOSFETs 41 and 44. In this way, a normal operation of the circuit when the power source voltage drops is ensured. As in the case of the circuit of Fig. 17, the $g_m$ values of the PMOSFETs 41 and 44 are selected to be smaller than those of the PMOSFETs 64 and 65. With this arrangement, the DC pass-current and the power consumption are made small.

Fig. 19 shows a complementary MOSFET logic circuit. The present embodiment also takes a measure for the power source drop which is applied to the Fig. 7 circuit. To be more specific, a PMOSFET 66 is connected between the output terminal of the CMOSFET subcircuit 23 in the Fig. 7 circuit, i.e. a connection point between the PMOSFET 21 and the NMOSFET 22 and a power source $V_{DD}$. An input signal IN is applied to the gate of the PMOSFET 66. The threshold voltage of the PMOSFET 66 is larger (smaller in the absolute value) than that of the PMOSFET 21 in the COMOSFET subciruit 23, as in the case of the Fig. 16 circuit. Thus, the present embodiment also can ensure a normal operation of the circuit when the power source voltage drops.

The complementary MOSFET logic circuits shown in Figs. 16 to 19 each have an electrical characteristic having a perfect compatibility with the TTL circuit and further ensures its normal operation when the power source voltage drops.

In the Fig. 19 circuit, the resistor 28 is omitted, but it may be provided as in the circuit of Fig. 7, if necessary.

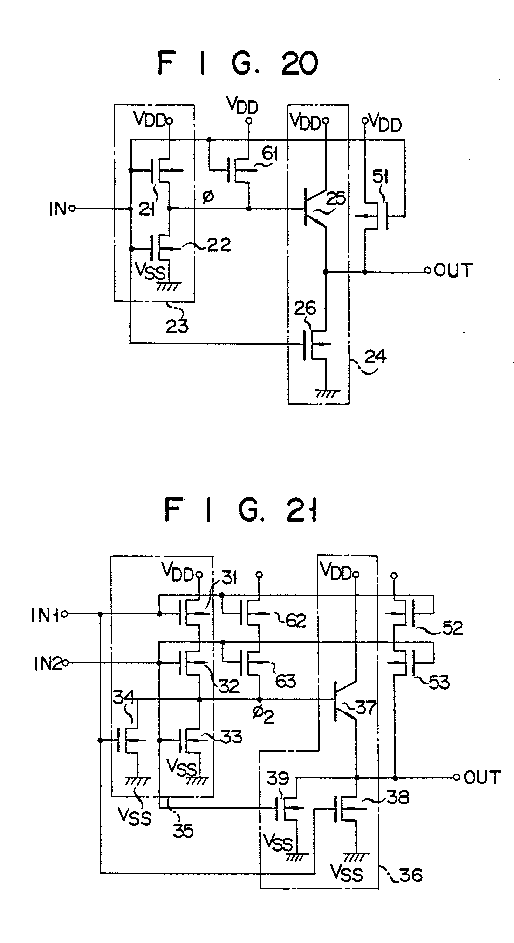

In Fig. 20 illustrating an embodiment of a complementary MOSFET logic circuit according to the present invention, a measure for the power source voltage drop problem is taken and applied for the Fig. 8 circuit. As shown, a PMOSFET 61 of which the threshold voltage is larger (smaller in the absolute value) than that of the PMOSFET 21 in the CMOSFET subcircuit 23, is connected between the output terminal of the CMOSFET subcircuit 23 in the Fig. 8 circuit, i.e. a connection point between the PMOSFET 21 and the NMOSFET 22.

In this circuit arrangement, the provision of the PMOSFET 51 enables the output signal OUT to swing to the full magnitude of the $V_{DD}$. Because of the provision of the PMOSFET 61, its normal operation is ensured even when the power source voltage $V_{DD}$ drops from the normal value. By setting the $g_m$ of the PMOSFET 21 at a value larger than that of the PMOSFET 61, the DC pass-current and the power consumption may be made small.

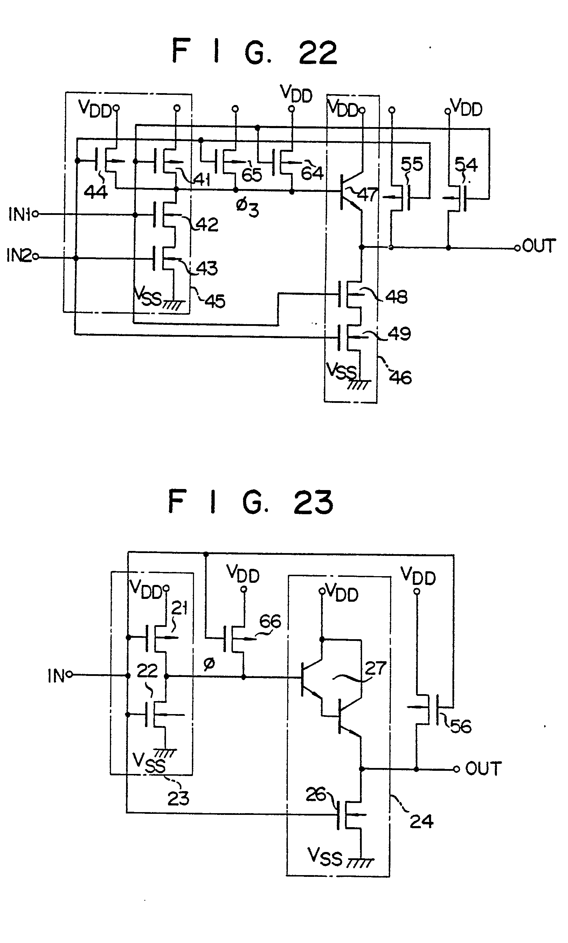

Fig. 21 shows a complementary MOSFET logic circuit which is another embodiment of the present invention. The present embodiment takes a measure taken for the power source voltage drop, which is applied to the Fig. 10 circuit. Two PMOSFETs 62 and 63 are connected in series between the output terminal of the CMOSFET subcircuit 35 in the Fig. 10 circuit, i.e. a connection point between the PMOSFET 32 and NMOSFET 33, and the power source $V_{DD}$. An input signal IN1 is applied to the gate of the PMOSFET 62 and another input signal IN2 is applied to the gate of the PMOSFET 63.

In the circuit, the threshold voltages of the two PMOSFETs 31 and 32 in the CMOSFET subcircuit 35 are selected to be equal to each other. Similarly, the threshold voltages of the PMOSFETs 62 and 63 are selected so as to have equal values. Further, by setting the threshold values of the latter FETs at values larger (smaller in the absolute value) than those of the former, a normal operation of the circuit is ensured when the power source voltage $V_{DD}$ drops from its normal value. Further, since the PMOSFETs 52 and 53 are provided, the circuit output signal OUT may be swung up to the $V_{DD}$.

Fig. 22 shows an additional embodiment of a complementary CMOSFET logic circuit according to the present invention. The present embodiment takes a measure for the power source voltage drop problem by making use of the Fig. 12 circuit. In the circuit, two PMOSFETs 64 and 65 are connected in parallel between the output terminal of the CMOSFET subcircuit 45 in the Fig. 12 circuit, i.e. a connection point between the PMOSFET 41 and NMOSFET 42, and the power source $V_{DD}$. An input signal IN1 is applied to the gate of the PMOSFET 64, while another input signal IN2 is applied to the gate of the PMOSFET 65.

Also in this circuit, threshold voltages of the two PMOSFETs 41 and 44 in the CMOSFET subcircuit 45 are selected to have equal values. The same thing is true for the threshold values of the PMOSFETs 64 and 65. The threshold values of the latter FETs are larger (smaller in the absolute value) than those of the former FETs. This feature ensures a normal operation of the circuit when the power source voltage drops. The provision of the PMOSFETs 54 and 55 allows the output signal OUT to swing up to the full amplitude of the $V_{DD}$.

Fig. 23 shows a circuit diagram of even a further embodiment of a complementary MOSFET logic circuit according to the present invention. The present embodiment takes another measure for the power source voltage drop by making use of the Fig. 14 circuit. A PMOSFET 66 of which the threshold voltage is larger (smaller in the absolute value) than that of the PMOSFET 21 in the CMOSFET subcircuit 23 is connected between the output terminal of the CMOSFET subcircuit 23 in the circuit shown in Fig. 14, i.e. a connection point between the PMOSFET 21 and the NMOSFET 22, and the power source $V_{DD}$.

In this circuit arrangement, the provision of the PMOSFET 56 allows the circuit output signal OUT to swing up to the full amplitude of the $V_{DD}$. The additional use of the PMOSFET 66 ensures a normal operation of the circuit when the power source voltage drops from its normal value. The resistor 28, which is omitted in the present circuit, may be provided, if necessary.

Accordingly, the complementary MOSFET logic circuit shown in Figs. 20 to 23 have each an electrical characteristic with a perfect compatibility with that of the TTL circuit. Further, it allows the circuit output signal OUT to swing to the full amplitude of $V_{DD}$. Additionally, when the power source voltage drops from its normal value, a normal operation of the circuit is ensured.

It should be understood that the present invention is not limited by the above-mentioned specific embodiments, but may be changed and modified variously. For example, the two-input CMOSFET subcircuits 35 and 45 may be replaced by three- or more-input CMOSFET subcircuits.

**Claims**

1. A TTL compatible complementary MOSFET logic circuit comprising:

an input terminal to which at least one input signal (IN; IN1; IN2) is supplied;

a circuit output terminal from which one logic signal (OUT) is output;

a complementary MOSFET subcircuit (23; 35; 45) having at least one P channel MOSFET (21; 31; 32; 41; 44), at least one N channel MOSFET (22; 33; 34; 42; 43) and a subcircuit output terminal from which a subcircuit output signal (φ) is output, and receiving the at least one input signal (IN1; IN2);

a buffer circuit (24; 36; 46) in which a bipolar transistor (25; 37; 47; 27) receiving at its base the subcircuit output signal (φ) and at least one N channel MOSFET (26; 38; 39; 48; 49) receiving at its gate the at least one input signal (IN; IN1; IN2) are inserted in series between a high potential applying point (VDD) and a low potential applying point (VSS), thereby outputting an output signal to said circuit output terminal which is common to both the bipolar transistor and the at least one N channel MOSFET; and

at least one first P channel MOSFET (51; 52; 53; 54; 55; 56) inserted between said circuit output terminal and said high potential applying point and receiving at its gate the at least one input signal (IN; IN1; IN2), characterized in that

the ratio of the channel sizes of said at least one P channel MOSFET (21; 31; 32; 41; 44) and said at least one N channel MOSFET (22; 33; 34; 42; 43) in said complementary MOSFET subcircuit (23; 35; 45) and the threshold voltages of said MOSFETs (21; 31; 32; 41; 44; 22; 33; 34; 42; 43) are set at such values as to produce an input voltage characteristic in said complementary MOSFET subcircuit (23; 35; 45) corresponding to an output voltage characteristic of a TTL circuit, and that at least one second P channel MOSFET (61; 62; 63; 64; 65; 66) is inserted between said high potential applying point and the subcircuit output terminal to which the output signal (φ) of said complementary MOSFET subcircuit (23; 35; 45) is supplied which at least one second P channel MOSFET is set at a lower threshold voltage than that of the P channel MOSFETs (21; 31; 32; 41; 44) in said complementary MOSFET subcircuit (23; 35; 45), and receives at its gate or gates the input signal (IN) or signals (IN1; IN2) respectively.

2. A TTL compatible complementary MOSFET logic circuit according to claim 1, characterized in that said complementary MOSFET subcircuit (23; 35; 45) is either an inverter or a NOR circuit or a NAND circuit.

3. A TTL compatible complementary MOSFET logic circuit according to claim 1 or 2, characterized in that in said buffer circuit (36), a plurality of N channel MOSFETs (38; 39) are connected in parallel which receive at their gates said input signals (IN1; IN2) respectively.

4. A TTL compatible complementary MOSFET logic circuit according to claim 1 or 2, characterized in that in said buffer circuit (46), a plurality of MOSFETs (48; 49) are connected in series and receive at their gates said input signals (IN1; IN2) respectively.

5. A TTL compatible complementary MOSFET logic circuit according to claim 2 or 4, characterized in that a plurality of said second P channel MOSFETs (62; 63), inserted between said high potential applying point and said output terminal of said complementary MOSFET sub-circuit (35), are connected in series, and receive at their respective gates the input signals (IN1; IN2) and have threshold voltages smaller than those of the corresponding P channel MOSFETs (31; 32) in said complementary MOSFET subcircuit (35).

6. A TTL compatible complementary MOSFET logic circuit according to claim 2 or 3, characterized in that a plurality of said second P channel MOSFETs (64; 65), inserted between said high potential applying point and the output terminal of said complementary MOSFET subcircuit (45) are connected in parallel, and receive at their gates the respective input signals (IN1; IN2) and have threshold voltages smaller than those of the corresponding P channel MOSFETs (41; 44) in said complementary MOSFET subcircuit (45).

7. A TTL compatible complementary MOSFET logic circuit according to any preceding claim, characterized in that the bipolar transistor of the buffer circuit (24) is a Darlington pair (27).

**Patentansprüche**

1. TTL-kompatible komplementäre MOSFET - Logikschaltung, umfassend
eine Eingangsklemme, der mindestens ein Einganssignal (IN; IN1; IN2) zuführbar ist,
eine Schaltungs-Ausgansklemme, an der ein logisches Signal (OUT) ausgebbar ist,
einen komplementären MOSFET - Nebenkreis (23; 35; 45) mit mindestens einem P-Kanal-MOSFET (21; 31; 32; 41; 44), mindestens einem N-Kanal-MOSFET (22; 33; 34; 42; 43) und einer Nebenkreis - Ausgangsklemme, an der ein Nebenkreis - Ausgangssignal (φ) ausgebbar ist, wobei der Nebenkreis das mindestens eine Eingangssignal (IN1; IN2) abnimmt,
einen Pufferkreis (24; 36; 46), in welchem ein Bipolartransistor (25; 37; 47; 27), der an seiner Basis das Nebenkreis - Ausgangssignal (φ) abnimmt, und mindestens ein N-Kanal-MOSFET (26; 38; 39; 48; 49), der an seiner Gate-Elektrode das mindestens eine Eingangssignal (IN; IN1; IN2) abnimmt, in Reihe zwischen einen Hochpotential - Anlegungspunkt (VDD) und einen Niedrigpotential - Anlegungspunkt (VSS) eingeschaltet sind, so daß ein Ausganssignal zur Schaltungs - Ausgangsklemme ausgebbar ist, die dem Bipolartransistor und dem mindestens einen N-Kanal-MOSFET gemeinsam zugeordnet ist, und
mindestens einen ersten P-Kanal-MOSFET (51; 52; 53; 54; 55; 56), der zwischen die Schaltungs - Ausgangsklemme und den Hochpotential - Anlegungspunkt eingeschaltet ist und an seiner Gate-Elektrode das mindestens eine Eingangssignal (IN; IN1; IN2) abnimmt,
dadurch gekennzeichnet, daß
das Verhältnis der Kanalgrößen des mindestens einen P-Kanal-MOSFETs (21; 31; 32; 41; 44) und des mindestens einen N-Kanal-MOSFETs (22; 33; 34; 42; 43) im komplementären MOSFET - Nebenkreis (23; 35; 45) sowie die Schwellenwertspannungen der MOSFETs (21; 31; 32; 41; 44; 22; 33; 34; 42; 43) auf solche Größen eingestellt sind, daß sich im komplementären MOSFET-Nebenkreis (23; 35; 45) eine Eingangsspannungs - Charakteristik entsprechend einer Ausgangsspannungs - Charakteristik einer TTL-Schaltung ergibt, und daß mindestens ein zweiter P-Kanal-MOSFET (61; 62; 63; 64; 65; 66) zwischen den Hochpotential - Anlegungspunkt und die Nebenkreis - Ausgangsklemme, zu welcher das Ausgangssignal (φ) des komplementären MOSFET-Nebenkreises (23; 35; 45) geliefert wird, eingeschaltet ist, wobei dieser mindestens eine zweite P-Kanal-MOSFET auf eine niedrige Schwellenwertspannung als die der P-Kanal-MOSFETs (21; 31; 32; 41; 44) im komplementären MOSFET - Nebenkreis (23; 35; 45) eingestellt ist und an seiner (seinen) Gate-Elektrode(n) das Eingangssignal (IN) bzw. die Eingangssignale (IN1; IN2) abnimmt.

2. TTL-kompatible komplementäre MOSFET - Logikschaltung nach Anspruch 1, dadurch gekennzeichnet, daß der komplementäre MOSFET - Nebenkreis (23; 35; 45) entweder ein Inverter oder ein NOR- oder NAND-Glied ist.

3. TTL-Kompatible komplementäre MOSFET - Logikschaltung nach Anspruch 1 oder 2, dadurch gekennzeichnet, daß im Pufferkreis (36) mehrere N-Kanal-MOSFETs (38, 39), die an ihren Gate-Elektroden die jeweiligen Eingangssignale (IN1; IN2) abnehmen, parallelgeschaltet sind.

4. TTL-kompatible komplementäre MOSFET - Logikschaltung nach Anspruch 1 oder 2, dadurch gekennzeichnet, daß im Pufferkreis (46) mehrere an ihren Gate - Elektroden die betreffenden Eingangssignale (IN1; IN2) abnehmende MOSFETs (48; 49) in Reihe geschaltet sind.

5. TTL-kompatible komplementäre MOSFET-Logikschaltung nach Anspruch 2 oder 4, dadurch gekennzeichnet, daß mehrere der zwischen den Hochpotential - Anlegungspunkt und die Ausgangsklemme des komplementären MOSFET - Nebenkreises (35) eingeschalteten zweiten P-Kanal-MOSFETs (62; 63) in Reihe geschaltet sind, an ihren jeweiligen Gate - Elektroden die Eingangssignale (IN1; IN2) abnehmen und Schwellenwertspannungen aufweisen, die kleiner sind als diejenigen der entsprechenden P-Kanal-MOSFETs (31; 32) im komplementären MOSFET - Nebenkreis (35).

6. TTl-kompatible komplementäre MOSFET - Logikschaltung nach Anspruch 2 oder 3, dadurch gekennzeichnet, daß mehrere der zwischen den Hochpotential - Anlegungspunkt und die Ausgangsklemme des komplementären MOSFET - Nebenkreises (45) eingeschalteten zweiten P-Kanal-MOSFETs (64; 65) parallelgeschaltet sind, an ihren Gate - Elektroden die betreffenden Eingangssignale (IN1; IN2) abnehmen und Schwellenwertspannungen aufweisen, die kleiner sind als diejenigen der entsprechenden P-Kanal-MOSFETs (41, 44) im komplementären MOSFET - Nebenkreis (45).

7. TTL-kompatible komplementäre MOSFET - Logikschaltung nach einem der vorangehenden Ansprüche, dadurch gekennzeichnet, daß der Bipolartransistor des Pufferkreises (24) ein Darlington-Paar (27) ist.

## Revendications

1. Circuit logique MOSFET complémentaire compatible TTL comprenant:

une borne d'entrée à laquelle au moins un signal d'entrée, (IN, IN1, IN2) est appliqué;

une borne de sortie de circuit à partir de laquelle un signal logique (OUT) est fourni;

un sous-circuit MOSFET complémentaire (23, 35, 45) comprenant au moins un MOSFET à canal P (21, 31, 32, 41, 44), au moins un MOSFET à canal N (22, 33, 34, 42, 43), et une borne de sortie de sous-circuit à partir de laquelle un signal de sortie de sous-circuit (φ) est fourni, et recevant au moins un signal d'entrée (IN1, IN2);

un circuit tampon (24, 36, 46) dans lequel un transistor bipolaire (25, 37, 47, 27) recevant sur sa base le signal de sortie (φ) du sous-circuit et au moins un MOSFET à canal N (26, 38, 39, 48, 49) recevant sur sa grille ledit au moins un signal d'entrée (IN, IN1, IN2) sont insérés en série entre un point d'application de potentiel élevé $V_{DD}$ et un point d'application de potentiel faible $V_{SS}$, fournissant ainsi un signal de sortie à la borne de sortie du circuit qui est commune au transistor bipolaire et audit au moins un MOSFET à canal N; et

au moins un premier MOSFET à canal P (51, 52, 53, 54, 55, 56) inséré entre la borne de sortie du circuit et le point d'application de potentiel élevé pour recevoir sur sa grille ledit au moins un signal d'entrée (IN, IN1, IN2),

caractérisé en ce que:

le rapport des dimensions de canal dudit au moins un MOSFET à canal P (21, 31, 32, 41, 44) et dudit au moins un MOSFET à canal N (22, 33, 34, 42, 43) dans le sous-circuit MOSFET complémentaire (23, 35, 45) et les tensions de seuil des MOSFET (21, 31, 32, 41, 44, 22, 33, 34, 42, 43) sont établis à des valeurs telles qu'elles produisent une caractéristique de tension d'entrée dans le sous-circuit MOSFET complémentaire (23, 35, 45) correspondant à une caractéristique de tension de sortie d'un circuit TTL, et en ce qu'au moins un second MOSFET à canal P (61, 62, 63, 64, 65, 66) est inséré entre le point d'application de potentiel élevé et la borne de sortie du sous-circuit à laquelle le signal de sortie (φ) du sous-circuit MOSFET complémentaire (23, 35, 45) est appliqué, au moins un second MOSFET à canal P étant choisi avec une tension de seuil inférieure à celle des MOSFET à canal P (21, 31, 32, 41, 44) dans le sous-circuit MOSFET complémentaire (23, 35, 45) et recevant sur sa ou ses grilles le (IN) ou les (IN1, IN2) signaux d'entrée, respectivement.

2. Circuit logique MOSFET complémentaire compatible TTL selon la revendication 1, caractérisé en ce que le sous-circuit MOSFET complémentaire (23, 35, 45) est ou bien un inverseur, ou bien un circuit NON OU, ou bien un circuit NON ET.

3. Circuit logique MOSFET complémentaire compatible au TTL selon l'une des revendications 1 ou 2, caractérisé en ce que, dans le circuit tampon (36) une pluralité de MOSFET à canal N (38, 39) sont connectés en parallèle et reçoivent sur leurs grilles lesdits signaux d'entrée (IN1, IN2), respectivement.

4. Circuit logique MOSFET complémentaire compatible TTL selon l'une des revendications 1 ou 2, caractérisé en ce que dans le circuit tampon (46) une pluralité de MOSFET (48, 49) sont connectés en série et reçoivent sur leurs grilles lesdits signaux d'entrée (IN1, IN2) respectivement.

5. Circuit logique MOSFET complémentaire compatible TTL selon l'une des revendications 2 ou 4, caractérisé en ce qu'une pluralité des seconds MOSFET à canal P (62, 63) insérés entre le point d'application de potentiel élevé et la borne de sortie du sous-circuit complémentaire MOSFET (35) sont connectés en série et reçoivent sur leur grille respective les signaux d'entrée (IN1, IN2) et présentent des tensions de seuil inférieures à celles des MOSFET à canal P correspondants (31, 32) dans le sous-circuit MOSFET complémentaire (35).

6. Circuit logique MOSFET complémentaire compatible TTL selon l'une des revendications 2 ou 3, caractérisé en ce qu'une pluralité de seconds MOSFET à canal P (64, 65), insérés entre le point d'application de potentiel élevé et la borne de sortie du sous-circuit MOSFET complémentaire (45) sont connectés en parallèle et reçoivent sur leur grille les signaux d'entrée respectifs (IN1, IN2) et présentent des tensions de seuil inférieures à celles des MOSFET à canal P correspondants (41 à 44) dans le sous-circuit MOSFET (45).

7. Circuit logique MOSFET complémentaire compatible TTL selon l'une quelconque des revendications précédentes, caractérisé en ce que le transistor bipolaire du circuit tampon (24) est constitué d'un montage Darlington (27).

# F I G. 1

# F I G. 2

# F I G. 3

# F I G. 4

# F I G. 5

# F I G. 6

# F I G. 7

# F I G. 8

# F I G. 9

# F I G. 11

# F I G. 10

# F I G. 12

# F I G. 13

# F I G. 14

# F I G. 15

# F I G. 16

# F I G. 17

# F I G. 18

# F I G. 19

# F I G. 20

# F I G. 21

# F I G. 22

# F I G. 23